# EUROPEAN PATENT APPLICATION

(11) **EP 2 495 778 A2**
(43) Date of publication of application: **05.09.2012**
(21) Application number: 12156639.2
(22) Date of filing: 23.02.2012
(51) Int. Cl.: H01L 41/22

(54) **Terminal electrode forming method and manufacturing method of piezoelectric/electrostrictive element by use thereof**

(30) Priority: 01.03.2011 JP 2011043880
(71) Applicant: NGK Insulators, Ltd., Nagoya-city, Aichi 467-8530 (JP)
(72) Inventor: Ebigase, Takashi, Nagoya-city, Aichi 467-8530 (JP)
(74) Representative: Naylor, Matthew John

(57) **Abstract**

There is provided a terminal electrode forming method which suppresses the lowering of an adhesive strength between an electrode and a ceramic so that the electrode and the ceramic do not easily peel off after forming a terminal electrode on the surface of the electrode formed on the surface of a ceramic and made of an electrode material containing a glass component. A terminal electrode 10 to connect a conducting wire is formed, with plating, on the surface of an electrode formed on the surface of the ceramic and made of an electrode material containing a glass component by the terminal electrode forming method. This method includes a first gold plating layer forming step of forming a first gold plating layer on the surface of the electrode with the plating by use of a plating liquid having a pH of 6 to 8, a nickel plating layer forming step of forming a nickel plating layer on the surface of the first gold plating layer with the plating, and a second gold plating layer forming step of forming a second gold plating layer on the surface of the nickel plating layer with the plating.

## Description

### BACKGROUND OF THE INVENTION

### Field of the Invention

The present invention relates to a method for forming a terminal electrode to connect a conducting wire, on the surface of an electrode formed on each surface of ceramics, such as an electrode of a piezoelectric/electrostrictive element which is used in a piezoelectric/electrostrictive device such as a piezoelectric/electrostrictive actuator.

### Description of the Related Art

In recent years, in fields of optics, precision machines, semiconductor manufactures and the like, there have actively been developed piezoelectric/electrostrictive devices such as piezoelectric/electrostrictive actuators utilizing distortion (displacement or deformation) which occurs when an electric field is applied to a piezoelectric body, and piezoelectric/electrostrictive sensors utilizing charge generation (polarization) which occurs when a pressure is applied to a piezoelectric material. As constitutional elements which are central cores of such piezoelectric/electrostrictive devices, piezoelectric/electrostrictive elements which are constituted of a piezoelectric/electrostrictive film made of a piezoelectric/electrostrictive material, and electrodes formed on both the surfaces of the piezoelectric/electrostrictive film are used (e.g., refer to Patent Document 1).

Usually in such a piezoelectric/electrostrictive element, there is formed, with plating, a portion which is referred to as a terminal electrode and to which a conducting wire is connected, on the surface of each of the electrodes formed on both the surfaces of the piezoelectric/electrostrictive film, respectively. Moreover, in mounting the piezoelectric/electrostrictive element, the conducting wire which connects the piezoelectric/electrostrictive element to a circuit for the application of a voltage to the piezoelectric/electrostrictive element, or the like is connected to the terminal electrode by use of a solder, a conductive adhesive, an anisotropic conductive film (ACF), or the like.

Usually as the terminal electrode, a terminal electrode having a two-layer structure constituted of a nickel plating layer and a gold plating layer is used owing to a high reliability thereof. As a forming method of such a terminal electrode, there has heretofore been used a method in which the nickel plating layer is first formed on the surface of the electrode with plating and the gold plating layer is formed on the surface of the nickel plating layer with the plating.

[Patent Document 1] JP-A-5-267742

### SUMMARY OF THE INVENTION

Meanwhile, a material of the electrode formed on the surface of a ceramic such as the piezoelectric/electrostrictive film of the piezoelectric/electrostrictive element usually contains a minute amount of a glass component as an additive, in addition to a main material such as gold or platinum. Moreover, the glass component is deposited in an interface between the electrode and the piezoelectric/electrostrictive film (the ceramic) by firing to exert a bond force, thereby bringing the electrode into contact closely with the piezoelectric/electrostrictive film (the ceramic).

In consequence, when the terminal electrode is formed, through the above plating method, on the surface of the electrode which comes in contact closely with the piezoelectric/electrostrictive film (the ceramic) by the glass component deposited in the interface, an adhesive strength between the electrode and the piezoelectric/electrostrictive film (the ceramic) lowers as compared with that before the formation of the terminal electrode. When or after the conducting wire is connected to the terminal electrode, the electrode and the piezoelectric/electrostrictive film (the ceramic) disadvantageously easily peel off.

As a cause for the lowering of the adhesive strength, it is considered that when the terminal electrode is formed, a plating liquid enters the interface between the electrode and the piezoelectric/electrostrictive film and that when a power for the plating is turned on, a gas pressure of a hydrogen gas generated from the plating liquid is applied to the interface.

Moreover, the plating liquid for nickel plating which is first used for the formation of the terminal electrode usually has an acidity (a pH of about 4 to 5). Therefore, as another cause for the lowering of the adhesive strength, it is considered that this plating liquid enters the interface between the electrode and the piezoelectric/electrostrictive film (the ceramic) to elute the glass component deposited in the interface between the electrode and the piezoelectric/electrostrictive film (the ceramic).

Furthermore, when the adhesive strength between the electrode and the piezoelectric/electrostrictive film (the ceramic) thus lowers and a stress during the connection of the conducting wire to the terminal electrode or various stresses after the connection are applied, the electrode and the piezoelectric/electrostrictive film (the ceramic) easily peel off.

The present invention has been developed in view of such a conventional situation, and an object thereof is to provide a terminal electrode forming method which suppresses the lowering of an adhesive strength between an electrode and a ceramic after forming a terminal electrode on the surface of the electrode formed on the surface of a ceramic such as a piezoelectric/electrostrictive film and made of an electrode material containing a glass component and in which the electrode and the ceramic do not easily peel off even in a case where various stresses are added when or after connecting a conducting wire to the terminal electrode, and a manufacturing method of a piezoelectric/electrostrictive element by use of the terminal electrode forming method.

To achieve the above object, the present invention provides the following terminal electrode forming method and the following manufacturing method of a piezoelectric/electrostrictive element.

[1] A terminal electrode forming method which forms, with plating, a terminal electrode to connect a conducting wire, on the surface of an electrode formed on the surface of a ceramic and made of an electrode material containing a glass component, the method comprising: a first gold plating layer forming step of forming a first gold plating layer on the surface of the electrode with the plating by use of a plating liquid having a pH of 6 to 8; a nickel plating layer forming step of forming a nickel plating layer on the surface of the first gold plating layer with the plating; and a second gold plating layer forming step of forming a second gold plating layer on the surface of the nickel plating layer with the plating.

[2] A manufacturing method of a piezoelectric/electrostrictive element including a piezoelectric/electrostrictive film made of a ceramic piezoelectric/electrostrictive material and electrodes formed on both the surfaces of the piezoelectric/electrostrictive film, respectively, the electrode formed on at least one of the surfaces of the piezoelectric/electrostrictive film being made of an electrode material containing a glass component, the surface of the electrode made of the electrode material containing the glass component being provided with a terminal electrode to connect a conducting wire, with plating, wherein the terminal electrode is formed by use of the terminal electrode forming method according to [1].

When a terminal electrode is formed by use of a terminal electrode forming method of the present invention, an adhesive strength between an electrode and a ceramic is kept to be high even after forming the terminal electrode. Even in a case where various stresses are added when or after connecting a conducting wire to the terminal electrode, the electrode and the ceramic do not easily peel off. Moreover, in a manufacturing method of a piezoelectric/electrostrictive element of the present invention, the terminal electrode is formed by use of the terminal electrode forming method of the present invention. Therefore, it is possible to manufacture the piezoelectric/electrostrictive element in which an adhesive strength between an electrode and a piezoelectric/electrostrictive film is kept to be high even after forming the terminal electrode and in which the electrode and the piezoelectric/electrostrictive film do not easily peel off even in a case where various stresses are added when or after connecting the conducting wire to the terminal electrode.

### BRIEF DESCRIPTION OF THE DRAWINGS

Fig. 1 is a schematic perspective view showing an example of a piezoelectric/electrostrictive element in which a terminal electrode is formed by a terminal electrode forming method of the present invention; and
Fig. 2 is a schematic sectional view around the terminal electrode.

### DESCRIPTION OF THE PREFERRED EMBODIMENTS

A terminal electrode forming method of the present invention is used for forming, with plating, a terminal electrode to connect a conducting wire, on the surface of an electrode formed on the surface of a ceramic and made of an electrode material containing a glass component. Hereinafter, this terminal electrode forming method will specifically be described with respect to an example where a terminal electrode of a piezoelectric/electrostrictive element is formed, but it should be understood that the present invention is not limited to this example when interpreted and that various changes, modifications and improvements can be added on the basis of the knowledge of a person skilled in the art, without departing from the scope of the present invention.

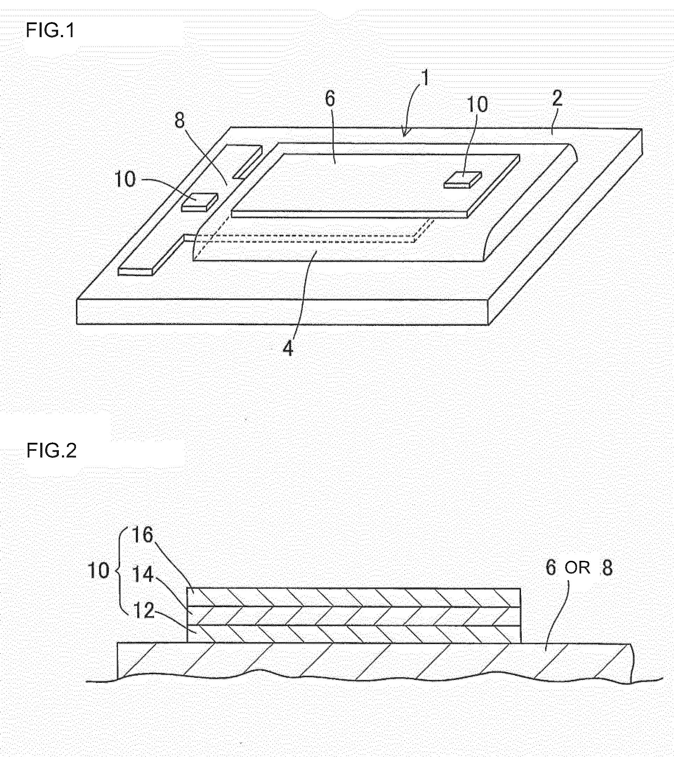

Fig. 1 is a schematic perspective view showing an example of a piezoelectric/electrostrictive element in which a terminal electrode is formed by a terminal electrode forming method of the present invention, and Fig. 2 is a schematic sectional view around the terminal electrode of the piezoelectric/electrostrictive element.

A piezoelectric/electrostrictive element in which a terminal electrode is formed by the terminal electrode forming method of the present invention includes, for example, a piezoelectric/electrostrictive film made of a ceramic piezoelectric/electrostrictive material, and electrodes formed on both the surfaces of the piezoelectric/electrostrictive film, respectively, and made of an electrode material containing a glass component. Such a piezoelectric/electrostrictive element can be manufactured by using a heretofore known manufacturing method.

For example, a piezoelectric/electrostrictive element 1 shown in Fig. 1 is manufactured by successively laminating, on a ceramic substrate 2, an electrode (a lower electrode) 8 made of an electrode material containing a glass component, a piezoelectric/electrostrictive film 4 made of a ceramic piezoelectric/electrostrictive material, and an electrode (an upper electrode) 6 made of an electrode material containing a glass component. It is to be noted that the piezoelectric/electrostrictive element 1 illustrated in Fig. 1 is provided on the ceramic substrate 2, to constitute a piezoelectric/electrostrictive actuator together with the ceramic substrate 2. However, the piezoelectric/electrostrictive element in which the terminal electrode is formed by the terminal electrode forming method of the present invention does not have to be provided on the ceramic substrate in this manner, or does not have to be used as a constitutional element of the piezoelectric/electrostrictive actuator. Moreover, the piezoelectric/electrostrictive element in which the terminal electrode is formed by the terminal electrode forming method of the present invention is not limited to a simple structure in which the electrodes are thus provided on both the surfaces of one piezoelectric/electrostrictive film, respectively. For example, the piezoelectric/electrostrictive element may have a multilayer structure in which, for example, electrodes are interposed among a plurality of piezoelectric/electrostrictive films.

In a specific example of a manufacturing method of the piezoelectric/electrostrictive element 1 shown in Fig. 1, the ceramic substrate 2 is first prepared as a basic body on which the lower electrode 8, the piezoelectric/electrostrictive film 4 and the upper electrode 6 are laminated.

Examples of a material of the ceramic substrate 2 preferably include zirconium oxide, aluminum oxide, magnesium oxide, aluminum nitride, and silicon nitride. In particular, a material containing completely stabilized zirconium oxide or partially stabilized zirconium oxide as a main component is most preferably used, because even when the material has a small thickness, the material has a large mechanical strength, a high toughness, and a low reactivity with the materials of the piezoelectric/electrostrictive film and electrodes.

A specific example of a preparing method of the ceramic substrate 2 includes adding and mixing a binder, a solvent, a dispersant, a plasticizer or the like with powder of the above material to obtain a slurry, after defoam treating this slurry, forming a green sheet by using a process such as a reverse roll coater process or a doctor blade process, and firing at a predetermined temperature (e.g., about 1200 to 1600°C when zirconium oxide is used as the material). It is to be noted that the firing may be performed after forming the lower electrode 8, after forming the piezoelectric/electrostrictive film 4, or after forming the upper electrode 6 as described later.

On the ceramic substrate 2 prepared in this manner, the lower electrode 8 is formed. Examples of a main material of the lower electrode 8 preferably include a single metal such as platinum, gold, aluminum, titanium, chromium, iron, cobalt, nickel, copper, zinc, niobium, molybdenum, ruthenium, palladium, rhodium, silver, tin, tantalum, tungsten, iridium, or lead, and an alloy thereof. In particular, platinum is most preferably used, because platinum exhibits an excellent heat resistance at a film firing temperature (1000 to 1300°C) in a forming step of the piezoelectric/electrostrictive film 4 described later. Moreover, the material of the lower electrode 8 preferably contains a minute amount of a glass component as an additive, in addition to the above main material. This glass component is deposited in an interface between the ceramic substrate 2 and the lower electrode 8 to exert a bond force during the firing of the lower electrode 8, whereby it is possible to enhance an adhesion between the ceramic substrate 2 and the lower electrode 8. Furthermore, when the film is fired in the forming step of the piezoelectric/electrostrictive film 4 described later, the glass component which is not deposited in the interface during the firing of the lower electrode 8 but remains in the electrode is deposited in an interface between the lower electrode 8 and the piezoelectric/electrostrictive film 4 to exert the bond force, whereby it is possible to enhance an adhesion between the lower electrode 8 and the piezoelectric/electrostrictive film 4.

The lower electrode 8 can be formed on the ceramic substrate 2 by a heretofore known film forming method. In a specific example of the forming method, a predetermined position on the ceramic substrate 2 is coated with a metal resinate paste such as a platinum resinate paste or a gold resinate paste containing the minute amount of the glass component, or a metal paste obtained by mixing metal powder of platinum or gold, the glass component and a resin by a film forming method such as a printing method, a dipping method or a transfer method, and fired at a predetermined temperature (e.g., about 1300°C when the platinum resinate paste is used). As to a thickness of the lower electrode 8, the electrode is preferably formed to be thin so that the displacement of the piezoelectric/electrostrictive film 4 is not disturbed, and the thickness thereof is usually 20 µm or less, preferably 2 µm or less, and more preferably 0.5 µm or less.

Next, on the lower electrode 8, the piezoelectric/electrostrictive film 4 is formed. There is not any special restriction on a material of the piezoelectric/electrostrictive film 4 as long as the material is a ceramic material which causes an electrically induced distortion due to a piezoelectric or electrostrictive effect or the like. It is also possible to use a ferroelectric ceramic or an antiferroelectric ceramic. Specific examples of the material include ceramics containing lead zirconate, lead titanate, lead magnesium niobate, lead nickel niobate, lead zinc niobate, lead manganese niobate, lead antimony stannate, lead manganese tungstate, lead cobalt niobate, barium titanate, sodium bismuth titanate, bismuth neodymium titanate (BNT), potassium sodium niobate, strontium bismuth tantalate, or the like alone, or as a mixture or a solid solution thereof. In particular, there is preferably used a material obtained by dissolving a material containing lead magnesium niobate (PMN) as a main component in lead zirconate titanate (PZT), or a material obtained by adding a minute amount of strontium oxide or niobium oxide to lead zirconate titanate (PZT), because it is possible to obtain a stable composition having a high electromechanical coupling coefficient, a high piezoelectric constant, and a low reactivity with the ceramic substrate 2 during the sintering of the piezoelectric/electrostrictive film 4.

The piezoelectric/electrostrictive film 4 can be formed on the lower electrode 8 by a heretofore known film forming method. In a specific example of the forming method, the lower electrode 8 is coated with a paste or a slurry containing particles of the above material as a main component by a film forming method such as a printing method, a dipping method or a transfer method, and fired at a predetermined temperature (e.g., about 1000 to 1300°C). A thickness of the piezoelectric/electrostrictive film 4 is preferably 100 µm or less, and more preferably 3 to 20 µm, to obtain a large displacement at a low operating voltage. Moreover, the surface of the piezoelectric/electrostrictive film 4 on which the upper electrode 6 is formed as described later preferably remains to be the fired surface as it is. This is because if the surface of the piezoelectric/electrostrictive film 4 is provided with unevenness by a treatment such as etching or blasting, or is smoothened by polishing or the like, piezoelectric/electrostrictive particles constituting the corresponding portion are damaged, and piezoelectric/electrostrictive particles which do not operate even when an electric field is applied thereto are present. Especially in the thin piezoelectric/electrostrictive film 4 described the above, a ratio of a portion which does not operate to a portion which operates increases, and eventually a displacement amount is entirely lowered.

In the present example, when the piezoelectric/electrostrictive film 4 is formed on the lower electrode 8, the whole surface of the lower electrode 8 is not covered with the piezoelectric/electrostrictive film 4, but part of the surface of the lower electrode 8 (a portion on which a terminal electrode 10 is to be formed) is not covered with the piezoelectric/electrostrictive film 4 but is exposed. The terminal electrode 10 is formed in the exposed portion by a method described later. It is to be noted that instead of the method of exposing part of the surface of the lower electrode 8 (the portion on which the terminal electrode 10 is to be formed) in this manner, there may be performed a method of providing a through hole which extends through the piezoelectric/electrostrictive film 4 in a thickness direction, and extending part of the lower electrode 8 to the upper surface of the piezoelectric/electrostrictive film 4 through the through hole to form the terminal electrode 10 in the extending portion as described later.

Next, on the piezoelectric/electrostrictive film 4, the upper electrode 6 is formed. Examples of a main material of the upper electrode 6 preferably include a single metal such as gold, platinum, aluminum, titanium, chromium, iron, cobalt, nickel, copper, zinc, niobium, molybdenum, ruthenium, palladium, rhodium, silver, tin, tantalum, tungsten, iridium, or lead, and an alloy thereof. In particular, the metal having a low reactivity with the piezoelectric/electrostrictive film material and excellent bond properties to the piezoelectric/electrostrictive film 4 is most preferably used. Moreover, the material of the upper electrode 6 contains a minute amount of a glass component as an additive, in addition to the above main material. This glass component is deposited in an interface between the upper electrode 6 and the piezoelectric/electrostrictive film 4 to exert a bond force during the firing of the upper electrode 6, thereby bringing the upper electrode 6 in contact closely with the piezoelectric/electrostrictive film 4.

The upper electrode 6 can be formed on the piezoelectric/electrostrictive film 4 by a heretofore known film forming method. In a specific example of the forming method, a predetermined position on the piezoelectric/electrostrictive film 4 is coated with a metal resinate paste such as the gold resinate paste containing a minute amount of the glass component by a film forming method such as a printing method, a dipping method or a transfer method, and fired at a predetermined temperature (e.g., about 600 to 900°C when the gold resinate paste is used). As to a thickness of the upper electrode 6, the electrode is preferably formed to be thin so that the displacement of the piezoelectric/electrostrictive film 4 is not disturbed, and the thickness thereof is usually 5 µm or less, preferably 2 µm or less, and more preferably 1 µm or less. It is to be noted that in the example of Fig. 1, the whole upper electrode 6 is formed on the piezoelectric/electrostrictive film 4, but the upper electrode 6 may be formed to bridge over the piezoelectric/electrostrictive film 4 and the ceramic substrate 2. Moreover, the electrodes (the upper electrode 6 and the lower electrode 8) are preferably formed so that to enhance an adhesive force to the piezoelectric/electrostrictive film 4, the glass component contained in an electrode material such as the gold resinate paste is present with a higher concentration in the interface between the electrode and the piezoelectric/electrostrictive film 4 than in the electrode after the firing. In particular, when the gold resinate paste is fired at such a temperature that particle diameters of metal particles constituting the electrode become 0.1 µm or more after the firing, fine pores each having a size of 100 nm or less are eliminated. In a plating layer forming step described later, the entrance of a plating liquid can preferably be prevented. This situation is preferable.

As the glass component contained in an electrode material such as the gold resinate paste, it is possible to use oxide, carbonate, hydroxide, organic metal compound or the like of Bi, Pb, Si, B, Na, Li, Ti or the like. A composition ratio thereof can appropriately be adjusted in accordance with the electrode material containing the glass component, the firing temperature, a type of the ceramic which becomes an electrode forming base, and the like. The composition ratio is adjusted so that all of the heat resistance, wettability with the ceramic and the adhesion thereto are satisfied in accordance with an application.

Next, on the surfaces of the electrodes (the upper electrode 6 and the lower electrode 8) of the piezoelectric/electrostrictive element 1 manufactured by the above manufacturing method, the terminal electrodes 10 are formed by use of the terminal electrode forming method of the present invention. The terminal electrode forming method of the present invention includes a first gold plating layer forming step, a nickel plating layer forming step and a second gold plating layer forming step described hereinafter. The terminal electrode 10 having a three-layer structure shown in Fig. 2 is formed by the method.

### (First Gold Plating Layer Forming Step)

This step is a step of forming a first gold plating layer 12 which is a lower layer of the terminal electrode 10 having the three-layer structure shown in Fig. 2 is formed on each of the surfaces of the lower electrode 8 and the upper electrode 6 with plating, respectively. As a plating method, a heretofore known plating method can be used. For example, gold plating bath using gold sulfite complex can be used. In this step, a pH of a plating liquid which is used in the plating is from 6 to 8, and preferably from 6.5 to 7.5. A substantially neutral plating liquid having a pH in such a range is used. In this case, even when the plating liquid enters the interface between the upper electrode 6 and the piezoelectric/electrostrictive film 4 and the interface between the lower electrode 8 and the film, the glass component which brings the upper electrode 6 and the lower electrode 8 closely with the piezoelectric/electrostrictive film 4 in the interfaces is not easily eluted. Specific examples of the plating liquid preferably include an electrolytic plating liquid using a gold sulfite complex. There is not any special restriction on a thickness of the first gold plating layer 12 formed in this step, but the thickness is preferably 0.1 µm or more from a viewpoint that the plating liquid for nickel plating is prevented from entering the interface in the nickel plating layer forming step described later. Moreover, when an immersing time into the plating liquid is long, an adhesive force lowers sometimes. Therefore, the thickness is preferably 0.5 µm or less (for a film forming time of 30 minutes or shorter). It is to be noted that when the terminal electrode 10 is formed on part of the surface of each of the lower electrode 8 and the upper electrode 6 as shown in Fig. 1, that is, when the electrodes are partially plated, portions which are not plated may be masked in photolithography using a known resist material.

### (Nickel Plating Layer Forming Step)

This step is a step of forming a nickel plating layer 14 which is a middle layer of the terminal electrode 10 having the three-layer structure shown in Fig. 2 on the surface of the first gold plating layer 12 formed in the first gold plating layer forming step, with plating. As a plating method, a heretofore known plating method can be used. For example, Watts bath can be used. Specific examples of a plating liquid preferably include a plating liquid which is usually used in Watts bath and obtained by adding boric acid as a buffer solution to nickel sulfate and nickel chloride. It is to be noted that a pH of the plating liquid for nickel plating is from about 4 to 5. There is not any special restriction on a thickness of the nickel plating layer 14 formed in this step, but the thickness is preferably from about 0.1 to 4.0 µm, and more preferably from about 0.2 to 1.0 µm from a viewpoint that electrode erosion by a solder (a state where the electrode is dissolved and eroded in the solder to cause a conducting defect) is prevented when connecting a conducting wire to the terminal electrode 10 by solder bonding.

### (Second Gold Plating Layer Forming Step)

This step is a step of forming a second gold plating layer 16 which is an upper layer of the terminal electrode 10 having the three-layer structure shown in Fig. 2 on the surface of the nickel plating layer 14 formed in the nickel plating layer step, with plating. As a plating method, a heretofore known plating method can be used. For example, gold plating bath using gold cyanide complex or gold sulfite complex can be used. A plating liquid which is used in this step may have such a pH that the nickel plating layer 14 or an exposed ceramic portion is not dissolved. Examples of the plating liquid preferably include an electrolytic plating liquid using the gold sulfite complex in the same manner as in the first gold plating layer forming step. There is not any special restriction on a thickness of the second gold plating layer 16 formed in this step, but the thickness is preferably from about 0.05 to 1.0 µm, and more preferably from about 0.1 to 0.4 µm from a viewpoint that solder wettability and solder bond properties are acquired when connecting a conducting wire to the terminal electrode 10 by solder bonding.

A difference between the above terminal electrode forming method of the conventional technology and the terminal electrode forming method of the present invention lies in that in the terminal electrode forming method of the conventional technology, the nickel plating layer is first formed on the surface of the electrode, and the gold plating layer is formed on the nickel plating layer, whereas in the terminal electrode forming method of the present invention, the gold plating layer (the first gold plating layer) is first formed on the surface of the electrode, the nickel plating layer is formed on the gold plating layer, and the gold plating layer (the second gold plating layer) is further formed on the surface of the nickel plating layer. That is, it can be considered that the terminal electrode forming method of the present invention is obtained by adding the first gold plating layer forming step to the terminal electrode forming method of the conventional technology.

The present inventors performed investigations by various experiments, and have found that when the first gold plating layer forming step is added as the first step in this manner, an adhesive strength between an electrode and a ceramic such as the piezoelectric/electrostrictive film after forming the terminal electrode becomes twice or more as much as that when the first gold plating layer forming step is not performed (the conventional technology).

A reason why the addition of the first gold plating layer forming step noticeably enhances the adhesive strength between the electrode and the ceramic piezoelectric/electrostrictive film after forming the terminal electrode is not certain. However, it can be considered that when the plating layer first formed on the surface of the electrode changes from the nickel plating layer of the conventional technology to the gold plating layer (the first gold plating layer), the following effects can be produced.

### (Effect 1)

The gold plating has a higher plating efficiency than the nickel plating. Therefore, when a power for the plating is turned on, less amount of a hydrogen gas is generated from the plating liquid which has entered the interface between the electrode and the ceramic piezoelectric/electrostrictive film. In consequence, a gas pressure of the hydrogen gas applied to the interface becomes low.

### (Effect 2)

In the nickel plating, an acidic plating liquid having a pH of about 4 to 5 is used, whereas in the gold plating, a substantially neutral plating liquid having a pH of about 6 to 8 is used. Therefore, even when the plating liquid enters the interface between the electrode and the ceramic piezoelectric/electrostrictive film, the glass component which brings the electrode into contact closely with the ceramic piezoelectric/electrostrictive film is not easily eluted in the interface.

When the terminal electrode is formed by use of the terminal electrode forming method of the present invention, the adhesive strength between the electrode and the ceramic piezoelectric/electrostrictive film is kept to be high even after forming the terminal electrode, owing to the above effects. Even in a case where various stresses are added when or after connecting the conducting wire to the terminal electrode, the electrode and the ceramic do not easily peel off, and a high reliability is exerted.

The terminal electrode forming method of the present invention has been described above with respect to the example where the terminal electrode of the piezoelectric/electrostrictive element is formed. However, an object on which the terminal electrode is formed by the terminal electrode forming method of the present invention is not limited to the piezoelectric/electrostrictive element. All elements or members in which the electrodes made of the electrode material containing the glass component are formed on the surfaces of the ceramics can be the objects.

Next, a manufacturing method of a piezoelectric/electrostrictive element of the present invention will be described. The manufacturing method of the piezoelectric/electrostrictive element of the present invention is a method for manufacturing the piezoelectric/electrostrictive element including a piezoelectric/electrostrictive film made of a ceramic piezoelectric/electrostrictive material and electrodes formed on both the surfaces of the piezoelectric/electrostrictive film, respectively. The electrode formed on at least one of the surfaces of the piezoelectric/electrostrictive material is made of an electrode material containing a glass component. The surface of the electrode made of the electrode material containing the glass component is provided with a terminal electrode to connect a conducting wire, with plating. The manufacturing method is mainly characterized in that the terminal electrode is formed by use of the terminal electrode forming method of the present invention described above.

In the manufacturing method of the piezoelectric/electrostrictive element of the present invention described above, the terminal electrode is formed by use of the terminal electrode forming method of the present invention. Therefore, it is possible to manufacture the piezoelectric/electrostrictive element in which the adhesive strength between the electrode and the piezoelectric/electrostrictive film is kept to be high even after forming the terminal electrode and in which the electrode and the piezoelectric/electrostrictive film do not easily peel off even in a case where various stresses are added when or after connecting the conducting wire to the terminal electrode. It is to be noted that the steps of the manufacturing method of the piezoelectric/electrostrictive element of the present invention except the terminal electrode forming step can be performed in conformity to, for example, the heretofore known manufacturing method of the piezoelectric/electrostrictive element described above. Examples

Hereinafter, the present invention will be described in more detail with respect to examples, but the present invention is not limited to these examples.

### (Example 1)

As a substrate material, a material made of zirconium oxide (3Y-ZrO₂) containing 3 mol% of Y₂O₃ was used. An organic solvent, a binder and the like were added to and mixed with this material, and then a plate-like formed body was formed by tape casting. This formed body was fired at 1450°C for two hours in the atmosphere, to prepare a ceramic substrate made of 3Y-ZrO₂. Next, this ceramic substrate was coated with a gold resinate paste containing 1 mass% of a glass component (an organic metal compound of Bi, Si and B was mixed so that a mole ratio in terms of metal elements became Bi:Si:B = 2:1:2) in gold, and fired at 600°C for 10 minutes in the atmosphere, to form an electrode having a thickness of 0.1 µm.

Next, on the surface of this electrode, a terminal electrode was formed. In a forming procedure of the terminal electrode, the surface of the electrode was first plated with a gold plating liquid which was an electrolytic plating liquid using gold sulfite complex and having a pH in a range of 6.5 to 7.5 at a temperature of 50°C, to form a first gold plating layer having a thickness of 0.1 µm. Next, the surface of this first gold plating layer was plated with a nickel plating liquid which was an electrolytic plating liquid obtained by adding boric acid as a buffer solution to nickel sulfate and nickel chloride and having a pH in a range of 4 to 5 at a temperature of 50°C, to form a nickel plating layer having a thickness of 0.5 µm. Then, the surface of this nickel plating layer was plated with the same gold plating liquid as that used in forming the first gold plating layer at a temperature of 50°C, to form a second gold plating layer having a thickness of 0.1 µm. Through the above procedure, there was obtained a sample in which the terminal electrode having a three-layer structure including the first gold plating layer, the nickel plating layer and the second gold plating layer was formed on the surface of the electrode.

### (Comparative Example 1)

In the same manner as in Example 1, a ceramic substrate made of 3Y-ZrO₂ was prepared, to form an electrode on the substrate, and then on the surface of the electrode, a terminal electrode was formed. In a forming procedure of the terminal electrode, the surface of the electrode was first plated with a nickel plating liquid which was an electrolytic plating liquid obtained by adding boric acid as a buffer solution to nickel sulfate and nickel chloride and having a pH in a range of 4 to 5 at a temperature of 50°C, to form a nickel plating layer having a thickness of 0.5 µm. Then, the surface of this nickel plating layer was plated with a gold plating liquid which was an electrolytic plating liquid using gold sulfite complex and having a pH in a range of 6.5 to 7.5 at a temperature of 50°C, to form a gold plating layer having a thickness of 0.1 µm. Through the above procedure, there was obtained a sample in which the terminal electrode having a two-layer structure including the nickel plating layer and the gold plating layer was formed on the surface of the electrode.

### (Example 2)

In the same manner as in Example 1, a ceramic substrate made of 3Y-ZrO₂ was prepared. Next, this ceramic substrate was coated with a platinum paste containing 1 mass% of a glass component (TiO₂) in platinum, and fired at 1300°C for two hours in the atmosphere, to form a lower electrode having a thickness of 2 µm. Next, this lower electrode was coated with a piezoelectric/electrostrictive ceramic paste including piezoelectric/electrostrictive material powder constituted of a composition obtained by dissolving 20 mol% of lead magnesium niobate (PMN) in lead zirconate titanate (PZT), a dispersant, a binder, a solvent, and the like, and was fired at 1250°C for two hours in a magnesia sheath in the atmosphere, to form a piezoelectric/electrostrictive film having a thickness of 10 µm. Then, this piezoelectric/electrostrictive film was coated with a gold resinate paste containing 1 mass% of a glass component (an organic metal compound of Bi, Si and B was mixed so that a mole ratio in terms of metal elements became Bi:Si:B = 2:1:2) in gold, and fired at 600°C for one minute in the atmosphere, to form an upper electrode having a thickness of 0.1 µm.

Next, on the surface of the upper electrode, a terminal electrode was formed. In a forming procedure of the terminal electrode, the surface of the upper electrode was first plated with a gold plating liquid which was an electrolytic plating liquid using gold sulfite complex and having a pH in a range of 6.5 to 7.5 at a temperature of 50°C, to form a first gold plating layer having a thickness of 0.1 µm. Next, the surface of this first gold plating layer was plated with a nickel plating liquid which was an electrolytic plating liquid obtained by adding boric acid as a buffer solution to nickel sulfate and nickel chloride and having a pH in a range of 4 to 5 at a temperature of 50°C, to form a nickel plating layer having a thickness of 0.5 µm. Then, the surface of this nickel plating layer was plated with the same gold plating liquid as that used in forming the first gold plating layer at a temperature of 50°C, to form a second gold plating layer having a thickness of 0.1 µm. Through the above procedure, there was obtained a sample in which the terminal electrode having a three-layer structure including the first gold plating layer, the nickel plating layer and the second gold plating layer was formed on the surface of the upper electrode.

### (Comparative Example 2)

In the same manner as in Example 1, a ceramic substrate made of 3Y-ZrO₂ was prepared. Next, a lower electrode, a piezoelectric/electrostrictive film and an upper electrode were successively laminated on this ceramic substrate, and then a terminal electrode was formed on the surface of the upper electrode in the same manner as in Example 2. In a forming procedure of the terminal electrode, the surface of the upper electrode was first plated with a nickel plating liquid which was an electrolytic plating liquid obtained by adding boric acid as a buffer solution to nickel sulfate and nickel chloride and having a pH in a range of 4 to 5 at a temperature of 50°C, to form a nickel plating layer having a thickness of 0.5 µm. Then, the surface of this nickel plating layer was plated with a gold plating liquid which was an electrolytic plating liquid using gold sulfite complex and having a pH in a range of 6.5 to 7.5 at a temperature of 50°C, to form a gold plating layer having a thickness of 0.1 µm. Through the above procedure, there was obtained a sample in which the terminal electrode having a two-layer structure including the nickel plating layer and the gold plating layer was formed on the surface of the upper electrode.

### (Evaluation)

The samples of Examples 1 and 2 and Comparative Examples 1 and 2 were subjected to a tape peel test and adhesive strength measurement, to evaluate an adhesive strength between the electrode and the ceramic substrate or the piezoelectric/electrostrictive film. The tape peel test was performed by a method of cutting a terminal electrode forming portion of each sample into a 1 mm square, attaching an adhesive cellophane tape (a mending tape manufactured by Sumitomo 3M Ltd. and having a width of 18 mm (product name: Scotch)) to the surface of the terminal electrode, and then peeling the tape from the surface thereof. When the tape was peeled, the electrode and the ceramic substrate or the piezoelectric/electrostrictive film did not peel off, which was evaluated as "good". When the electrode and the substrate or the film peeled off, the sample was evaluated as "bad". It is to be noted that the presence/absence of the peel was visually determined. Moreover, the measurement of the adhesive strength was performed by a method of cutting the terminal electrode forming portion of each sample into a 2 mm square, soldering a pin to the terminal electrode, and pulling the pin upwards in a vertical direction while the cut sample was fixed, to measure a peeling strength with a tensile tester. The results are shown in Table 1.

**[Table 1]**

| | Tape peel test result | Adhesive strength (g/mm²) |
|---|---|---|
| Example 1 | good | 2.2 |
| Comparative Example 1 | bad | 0.8 |
| Example 2 | good | 3.0 |
| Comparative Example 2 | bad | 1.3 |

As shown in Table 1, the sample of Example 1 obtained by forming the first gold plating layer before forming the nickel plating layer when forming the terminal electrode on the surface of the electrode was excellent in the result of the tape peel test, and the adhesive strength of the sample was twice or more as much as that of Comparative Example 1 in which the first gold plating layer was not formed, but the nickel plating layer was directly formed on the surface of the electrode. It has been confirmed that the adhesive strength between the electrode and the ceramic substrate of the sample is high. Similarly, the sample of Example 2 obtained by forming the first gold plating layer before forming the nickel plating layer when forming the terminal electrode on the surface of the electrode was excellent in the result of the tape peel test, and the adhesive strength of the sample was twice or more as much as that of Comparative Example 2 in which the first gold plating layer was not formed, but the nickel plating layer was directly formed on the surface of the electrode. It has been confirmed that the adhesive strength between the electrode and the piezoelectric/electrostrictive film of the sample is high.

The present invention can preferably be utilized as a method for forming a terminal electrode to connect a conducting wire, on the surface of an electrode formed on the surface of a ceramic, such as an electrode of a piezoelectric/electrostrictive element which is used in a piezoelectric/electrostrictive device such as a piezoelectric/electrostrictive actuator.

### Description of Reference Numerals

1: piezoelectric/electrostrictive element, 2: ceramic substrate, 4: piezoelectric/electrostrictive film, 6: upper electrode, 8: lower electrode, 10: terminal electrode, 12: first gold plating layer, 14: nickel plating layer, and 16: second gold plating layer.

## Claims

1. A terminal electrode forming method which forms, with plating, a terminal electrode to connect a conducting wire, on the surface of an electrode formed on the surface of a ceramic and made of an electrode material containing a glass component, the method comprising:
a first gold plating layer forming step of forming a first gold plating layer on the surface of the electrode with the plating by use of a plating liquid having a pH of 6 to 8;
a nickel plating layer forming step of forming a nickel plating layer on the surface of the first gold plating layer with the plating; and
a second gold plating layer forming step of forming a second gold plating layer on the surface of the nickel plating layer with the plating.

2. A manufacturing method of a piezoelectric/electrostrictive element including a piezoelectric/electrostrictive film made of a ceramic piezoelectric/electrostrictive material and electrodes formed on both the surfaces of the piezoelectric/electrostrictive film, respectively, the electrode formed on at least one of the surfaces of the piezoelectric/electrostrictive film being made of an electrode material containing a glass component, the surface of the electrode made of the electrode material containing the glass component being provided with a terminal electrode to connect a conducting wire, with plating,
wherein the terminal electrode is formed by use of the terminal electrode forming method according to claim 1.
